# EUROPEAN PATENT APPLICATION

(11) **EP 3 336 893 A1**
(43) Date of publication of application: **20.06.2018**
(21) Application number: 16834516.3
(22) Date of filing: 15.06.2016
(51) Int. Cl.: H01L 23/488, H01L 23/06, H01L 21/56, H01L 23/373, H01L 21/50, H01L 23/18

(54) **EMBEDDED SILICON SUBSTRATE FAN-OUT TYPE PACKAGING STRUCTURE AND MANUFACTURING METHOD THEREFOR**

(30) Priority: 11.08.2015 CN 201510486674
(71) Applicant: Huatian Technology (Kunshan) Electronics Co., Ltd, Kunshan, Jiangsu 215301 (CN)
(72) Inventor: YU, Daquan, Kunshan Jiangsu 215301 (CN)
(74) Representative: ABG Patentes, S.L.
(86) International application number: PCT/CN2016/085925
(87) International publication number: WO 2017/024892

(57) **Abstract**

Disclosed are an embedded silicon substrate fan-out type packaging structure and a manufacturing method therefor. A silicon substrate (1) is used to replace a molding compound to as a fan-out substrate, and fine wiring can be manufactured by making full use of the advantages of the silicon substrate (1). Structures of holes and grooves can be accurately etched by a mature silicon etching process. Chips (2) are embedded in the grooves on the silicon substrate (1), gaps between the chips (2) and the side walls of the grooves are filled with a polymer adhesive and partial solder balls (7) are fanned out on the surface of the silicon substrate (1), so that the packaging reliability can be improved. The process is simple and low in cost. Since the silicon substrate (1) has a good heat dissipation and a smaller warping degree, the improvement of the packaging heat dissipation is facilitated, adverse warping is overcome and smaller wiring line width is acquired, which is suitable for high-density packaging. With regard to the packaging structure, wafer plastic packaging can be eliminated, thus the process difficulty is reduced, the cost is significantly reduced and the yield is increased.

## Description

### TECHNICAL FIELD

The present invention relates to the field of semiconductor packaging technology, particularly to an embedded silicon substrate fan-out type packaging structure and a manufacturing method therefor.

### BACKGROUND

As a chip becomes smaller and smaller, and the number of I/Os is more and more, chip level package can't meet I/O fan-out requirements. Fan-out Wafer Level Package (FOWLP) technology is a supplement to wafer level chip size packaging technology. With leading out I/O ports of a chip by the method of reconfiguring wafer and forming solder balls or bumps terminal array in the reconfigured encapsulation, FOWLP may replace traditional Wire Bonding Ball Grid Array (WBBGA) package or Flip Chip Ball Grid Array (FCBGA) package (<500 I/Os) in a certain range, thus it is especially suitable for the booming portable consumer electronics field.

FOWLP process began in 2008, which mainly relates to eWLB (Embedded Wafer Level BGA) technology of Infineon wireless (later Intel's wireless department). Package foundry is mainly in STATS Chip PAC, NANIUM, which mainly uses baseband chip package of Intel's wireless department. As FOWLP technology matures gradually and costs continue to drop, along with continuous improvement of chip technology (baseband chips and mobile terminal application processor chips have entered 28 nm mass production), there may be an explosive growth in FOWLP. In order to achieve cost reduction, it will develop towards Panel Size Fan-out WLP (PWLP), and may be realized by using a packaging substrate process.

The standard eWLB process flow is as follows: firstly, a film is attached to a slide, and then a chip is placed on the film with the pad surface of the chip facing down; the chip is embedded into a molding compound using a wafer level injection molding process; the molding compound is cured, and the slide is removed. Then a wafer level process is carried out on the molding compound wafer embedded with the chip. Passivation, metal rewiring, under bump metal layers preparation and balls plantation are carried out on the side of the chip where the pads are exposed, and finally the package is finished by slicing.

Patent Publications US20080308917 and US2015003000 use polymers or other plastic sealing materials to coat a number of chips, so the chips are embedded in them, and then a wafer level process is carried out. The method has the following main problems. Firstly, there is a problem of warping of the polymer adhesive wafer. Although using a silicon or glass slide may reduce warpage, it will result in a complex process of temporary bonding and debonding. If a new type of low warpage molding compound is researched and developed, the material cost is high. Secondly, for a 10× 10 mm to 12×12 mm fan-out encapsulation, the reliability of board level has great challenges, especially for the tests related to temperature cycling. For eWLB products, an underfill adhesive is needed to improve the reliability after board level connection. Thirdly, the use of the polymer adhesive wafer has a great influence on yield. Chip offset is a major technological obstacle in the process of injection molding and molding compound curing. Another key point is the choice of rewiring dielectric materials. Since a reconfigured wafer needs to adapt to the rewiring process, and the standard wafer level media can't be directly applied.

Patent Publication CN104037133A discloses a fan-out packaging structure. The structure is grooved on a silicon carrier board, a chip is inverted at the bottom of the groove, and the electrical property of the chip pads is led to the surface of the silicon carrier board through circuits. The groove is filled with a plastic sealing material, and the circuit is derived electrically by a rewiring metal made on the surface of the plastic sealing material. Thus the structure and process of the fan-out packaging structure are very complex, and the cost is high.

In order to solve the above problems, a new fan-out solution with good processability, high reliability and low cost is required to be developed.

### SUMMARY

In order to solve the above technical problems, the present invention provides an embedded silicon substrate fan-out type packaging structure and a manufacturing method therefor, which uses a silicon substrate instead of a molding compound as a fan-out substrate, may make fine wiring by making full use of the advantages of the silicon substrate, may accurately etch holes, grooves and other structures by using the mature silicon etching process, and has a good heat dissipation performance. In the process, the wafer plastic molding and debonding process may be eliminated, which reduces the difficulty of the process, thus the cost is significantly reduced and the yield is improved.

Technical solution of the present invention is implemented as follows:
An embedded silicon substrate fan-out type packaging structure comprises a silicon substrate having a first surface and a second surface opposite thereto, at least one groove extending towards the second surface is formed on the first surface, and side walls of the groove are perpendicular or nearly perpendicular to the bottom of the groove. At least one chip is placed in the groove, and the pad surface of the chip is opposite to the bottom of the groove and close to the first surface. An adhesive layer is arranged between the bottom of the chip and the bottom of the groove, gaps are formed between the sides of the chip and the side walls of the groove, and the gaps are filled with a first dielectric layer. A second dielectric layer is formed on the chip and the first surface. At least one layer of metal wiring connected to the pads of the chip is formed on the second dielectric layer. The outermost layer of metal wiring is covered with a passivation layer, and under bump metal layers for planting solder balls are formed on the outermost layer of metal wiring. The passivation layer is provided with openings corresponding to the under bump metal layers, and the solder balls or bumps are planted on the under bump metal layers. At least one solder ball or bump and the under bump metal layer corresponding thereto are on the first surface of the silicon substrate.

As a further improvement of the present invention, the distance between the side walls of the groove and the chip is greater than 1 micron.

As a further improvement of the present invention, the distance between the bottom of the groove and the second surface of the silicon substrate is greater than 1 micron.

As a further improvement of the present invention, the height difference between the pad surface of the chip and the first surface of the silicon substrate is less than 50 microns.

As a further improvement of the present invention, the first dielectric layer is made of a polymer adhesive.

As a further improvement of the present invention, the first dielectric layer and the second dielectric layer are made of the same kind of polymer adhesive.

As a further improvement of the present invention, the adhesive layer has a thickness of less than 50 microns and greater than 1 micron.

As a further improvement of the present invention, the adhesive layer is a non-conductive polymer adhesive or film.

As a further improvement of the present invention, the metal wiring is made of copper or aluminum.

As a further improvement of the present invention, the solder balls are copper pillar solder bumps or solder balls.

As a further improvement of the present invention, the under bump metal layers are made of one of Ni/Au, Cr/W/Cu, Ti/W/Cu/Ni/Au and Ti/Cu.

A manufacturing method for an embedded silicon substrate fan-out type packaging structure includes the following steps:
A. providing a silicon substrate wafer having a first surface and a second surface opposite thereto, and etching the first surface of the silicon substrate wafer to form at least one groove having a set shape and depth;
B. placing at least one chip to be packaged in the groove, with a pad surface of the chip facing upwards, the back of the chip being coated with a certain thickness of adhesive, bonding the chip and the bottom of the groove through the adhesive, and curing the adhesive to form an adhesive layer, the pad surface of the chip being close to the first surface of the silicon substrate and gaps being formed between the chip and the side walls of the groove;
C. filling a polymer adhesive in the gaps between the side walls of the groove and the chip by a coating process, and curing the polymer adhesive to form an insulating first dielectric layer;
D. forming an insulating second dielectric layer on the pad surface of the chip and the first surface of the silicon substrate;
E. opening the second dielectric layer above the pads of the chip, and making metal wiring connected to the pads of the chip on the second dielectric layer;
F. forming a passivation layer on the metal wiring, opening the passivation layer on the metal wiring where solder balls need to be planted, preparing required under bump metal layers on the exposed metal wiring, then performing bumps preparation or solder balls plantation, and finally slicing to form an embedded silicon substrate fan-out type packaging structure.

As a further improvement of the present invention, the second surface of the silicon substrate wafer is thinned before and after the bumps preparation or the solder balls plantation, and the thickness between the bottom of the groove and the second surface of the silicon substrate is greater than 1 micron after the second surface is thinned.

As a further improvement of the present invention, the chip wafer to be packaged is thinned to a set thickness, then the adhesive is attached on the non-pad surface of the chip wafer, and a single chip is formed after the chip wafer is sliced. The single chip attached with the adhesive is placed in the groove of the silicon substrate using a pick-up tool.

As a further improvement of the present invention, filling the polymer adhesive in the gaps between the side walls of the groove and the chip is implemented in a vacuum environment.

As a further improvement of the present invention, the second dielectric layer is made of a photolithographic material.

Beneficial effects of the present invention include: the embedded silicon substrate fan-out type packaging structure and the manufacturing method therefor according to the present invention use a silicon substrate instead of a molding compound as a fan-out substrate, which may make fine wiring by making full use of the advantages of the silicon substrate, and may accurately etch holes, grooves and other structures by using the mature silicon etching process. The chip is embedded in the groove of the silicon substrate, and partial solder balls are fanned out to the surface of the silicon substrate, thus the reliability of the package can be improved, the process is simple and low in cost. Since the silicon substrate has a good heat dissipation, the improvement of the packaging heat dissipation is facilitated. As the silicon substrate wafer has a small warping degree, small wiring line widths may be acquired and it is suitable for high-density package. In the process, the wafer plastic molding and the debonding process may be eliminated in the present invention, which reduces the difficulty of the process, thus the cost is significantly reduced and the yield is improved. The chip offset may be prevented by filling the gaps between the chip and the side walls of the groove with the polymer adhesive. Preferably, the chip is bonded to the bottom of the groove through the adhesive layer, so that the chip may be fixed well and the chip offset can be avoided. Preferably, the reliability of the package may be improved by forming the first dielectric layer and the second dielectric layer with the same polymer adhesive.

### BRIEF DESCRIPTION OF DRAWINGS

FIG. 1 is a schematic diagram illustrating a fan-out type packaging structure in which one chip is embedded in one groove according to an embodiment of the present invention.
FIG. 2 is a schematic diagram illustrating a fan-out type packaging structure in which two chips are embedded in one groove according to an embodiment of the present invention.
FIG. 3 is a schematic diagram illustrating a fan-out type packaging structure in which two different chips are embedded in two grooves respectively according to an embodiment of the present invention.

**Explanations of symbols:**

| | | | |
|---|---|---|---|
| 1 | silicon substrate | 101 | first surface |
| 102 | second surface | 2 | chip |
| 201 | pad | 3 | first dielectric layer |
| 4 | second dielectric layer | 5 | metal wiring |
| 6 | passivation layer | 7 | solder ball or bump |
| 8 | adhesive layer | | |

### DETAILED DESCRIPTION

In order to make the present invention easy to understood, the following embodiments are described in detail, and their purpose is only to help understanding of the contents of the present invention, rather than limiting the protection scope of the present invention. The components of structures in the drawings of the embodiments are not scaled according to normal proportions, which does not represent actual relative size of structures in the embodiments.

### Embodiment 1

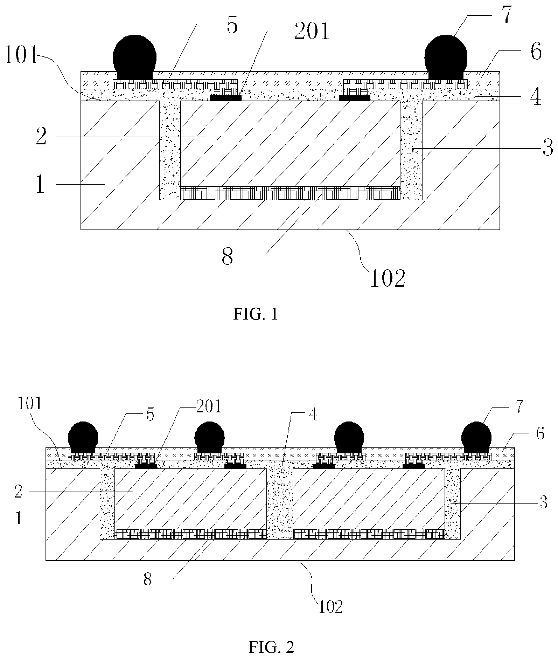

As shown in FIG. 1, an embedded silicon substrate fan-out type packaging structure comprises a silicon substrate 1 which has a first surface 101 and a second surface 102 opposite thereto. A groove extending towards the second surface is formed on the first surface. Preferably, the groove is a straight groove or an inclined groove with an angle between the side walls and the bottom of 80° to 120° , which is not limited here. Shown in the schematic diagram of the present embodiment is a shape of the straight groove. A chip 2 is placed in the groove, and a pad surface of the chip faces upwards and is close to the first surface. An adhesive layer 8 is attached between the chip and the bottom of the groove, and the chip is bonded to the bottom of the groove through the adhesive layer, so that the chip may be fixed well and the chip offset can be avoided.

There are gaps between the chip and the side walls of the groove, and the gaps are filled with a first dielectric layer 3. The chip and the first surface are paved with an insulating second dielectric layer 4. At least one layer of metal wiring 5 which is connected to pads 201 of the chip is formed on the second dielectric layer. The outermost layer of metal wiring is covered with a passivation layer 6, and under bump metal layers for planting solder balls are formed on the outermost layer of metal wiring. The passivation layer is provided with openings corresponding to the under bump metal layers, and the solder balls or bumps 7 are planted in the openings. At least one solder ball or bump and the under bump metal layer corresponding thereto are on the first surface.

Preferably, the distance between the side walls of the groove and the chip is greater than 1 micron, so that the chip can be conveniently placed on the bottom of the groove.

Preferably, the distance between the bottom of the groove and the second surface of the silicon substrate is greater than 1 micron to facilitate the support of the silicon substrate to the chip.

Preferably, the height difference between the pad surface of the chip and the first surface of the silicon substrate is less than 50 microns to ensure the uniformity of the material on the surface of the package.

Preferably, the first dielectric layer is made of a polymer adhesive, and the vacuum coating is applied to fill the polymer adhesive in the gaps of the groove to fix the chip and ensure the insulation performance.

Preferably, the first dielectric layer and the second dielectric layer are made of the same kind of polymer adhesive to improve the reliability of the package.

Preferably, the adhesive layer is a non-conductive polymer adhesive or film, bonding the chip and the bottom of the groove, which ensures that the position of the chip does not shift in the subsequent process, so as to get good alignment accuracy and fine rewiring lines. The polymer adhesive may be prepared by coating on the back of the chip wafer, and the film may be prepared by pressing film on the back of the chip wafer.

Preferably, the metal wiring is made of copper or aluminum.

Preferably, the solder balls are copper pillar solder bumps or solder balls.

Preferably, the under bump metal layers are made of one of Ni/Au, Cr/W/Cu, Ti/W/Cu/Ni/Au and Ti/Cu, which is not shown in the diagram. The Ni/Au means a layer of metal nickel is formed firstly and then a layer of metal gold is formed on the metal nickel. Similarly, the Cr/W/Cu means three layers of metal chromium, metal tungsten and metal copper are formed sequentially, the Ti/W/Cu/Ni/Au means five layers of metal titanium, metal tungsten, metal copper, metal nickel and metal gold are formed sequentially, and the Ti/Cu means two layers of metal titanium and metal copper are formed sequentially.

As a preferred embodiment, a manufacturing method for the embedded silicon substrate fan-out type packaging structure is implemented as the following steps:
A. providing a silicon substrate wafer having a first surface and a second surface opposite thereto, and etching the first surface of the silicon substrate wafer to form at least one groove having a set shape and depth;
B. placing at least one chip to be packaged in the groove, with a pad surface of the chip facing upwards, the back of the chip being coated with a certain thickness of adhesive, bonding the chip and the bottom of the groove through the adhesive, and curing the adhesive to form an adhesive layer, the pad surface of the chip being close to the first surface of the silicon substrate and gaps being formed between the chip and the side walls of the groove;
C. filling an adhesive in the gaps between the side walls of the groove and the chip by a coating process, and curing the adhesive to form an insulating first dielectric layer;
D. forming an insulating second dielectric layer on the pad surface of the chip and the first surface of the silicon substrate;
E. opening the second dielectric layer above the pads of the chip, and making metal wiring connected to the pads of the chip on the second dielectric layer;
F. forming a passivation layer on the metal wiring, opening the passivation layer on the metal wiring where solder balls need to be planted, preparing required under bump metal layers on the exposed metal wiring, then performing bumps preparation or solder balls plantation, and finally slicing to form an embedded silicon substrate fan-out type packaging structure.

Preferably, the coating process in step C adopts a polymer adhesive, and in step D, the second dielectric layer and the first dielectric layer are made of the same polymer adhesive, so as to improve the reliability of the package.

Preferably, the second surface of the silicon substrate wafer is thinned to a required thickness before and after the bumps preparation or the solder balls plantation. Preferably, the thickness between the bottom of the groove and the second surface of the silicon substrate is greater than 1 micron after the second surface is thinned.

Preferably, the chip wafer to be packaged is thinned to a set thickness, then the adhesive is attached on the non-pad surface of the chip wafer, and a single chip is formed after the chip wafer is sliced. The single chip attached with the adhesive is placed in the groove of the silicon substrate using a pick-up tool.

Preferably, filling the adhesive in the gaps between the side walls of the groove and the chip is implemented in a vacuum environment, which may reduce the bubbles and ensure the gap filling effect.

Preferably, the second dielectric layer and the passivation layer are made of a photolithographic material, so as to form openings by using a photolithography process to expose the pads of the chip and connect the metal wring to the pads.

### Embodiment 2

As shown in FIG. 2, the present embodiment 2 includes all the technical features of the embodiment 1, and the difference is that the groove on the first surface of the silicon substrate is embedded with two chips 2. The sizes and functions of the two chips may be the same or different. The embodiment may extend the functionality of the package.

### Embodiment 3

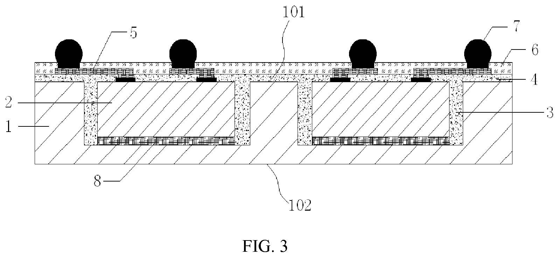

As shown in FIG. 3, the present embodiment 3 includes all the technical features of the embodiment 1, and the difference is that, the first surface of the silicon substrate is formed with two grooves, and each groove is embedded with one chip 2 respectively. The sizes and functions of the two chips may be the same or different. The embodiment may extend the functionality of the package and reduce the signal interference between the two chips.

The embedded silicon substrate fan-out type packaging structure and the manufacturing method therefor according to the present invention use a silicon substrate instead of a molding compound as a fan-out substrate, which may make fine wiring by making full use of the advantages of the silicon substrate, and may accurately etch holes, grooves and other structures by using the mature silicon etching process. Chips are embedded in the grooves of the silicon substrate, bonded and fixed to the bottom of the grooves through the adhesive layers, which avoids the chips offset. I/O ports are fanned out to the surface of the chips and the silicon substrate through rewiring, the reliability of the package can be improved, the process is simple and low in cost. Since the silicon substrate has a good heat dissipation, the improvement of the packaging heat dissipation is facilitated. As the silicon substrate wafer has a small warping degree, it may get small wiring line widths and is suitable for high-density package. In the process, the wafer plastic molding and the debonding process may be eliminated in the present invention, which reduces the difficulty of the process, thus the cost is significantly reduced and the yield is improved. The chip offset may be prevented by filling the gaps between the chips and the side walls of the grooves with the polymer adhesive. Preferably, the reliability of the package may be improved by forming the first dielectric layer and the second dielectric layer with the same polymer adhesive.

The preferred embodiments of the present invention are described in detail with reference to drawings. Various changes and modifications for the forms of the above embodiments made by those skilled in the art, but without departing from the essence of the present invention, will fall into the protection scope of the present invention.

## Claims

1. An embedded silicon substrate fan-out type packaging structure, comprising a silicon substrate (1), wherein the silicon substrate has a first surface (101) and a second surface (102) opposite thereto, at least one groove extending towards the second surface is formed on the first surface, side walls of the groove are perpendicular or nearly perpendicular to a bottom of the groove, at least one chip (2) is placed in the groove, and a pad surface of the chip is opposite to the bottom of the groove and close to the first surface; an adhesive layer (8) is attached between a bottom of the chip and the bottom of the groove, there are gaps between sides of the chip and the side walls of the groove, and the gaps are filled with a first dielectric layer (3); a second dielectric layer (4) is formed on the chip and the first surface; at least one layer of metal wiring (5) connected to pads (201) of the chip is formed on the second dielectric layer, an outermost layer of metal wiring is covered with a passivation layer (6), under bump metal layers for planting solder balls are formed on the outermost layer of metal wiring, the passivation layer is provided with openings corresponding to the under bump metal layers, and solder balls or bumps (7) are planted on the under bump metal layers; and at least one solder ball or bump and at least one under bump metal layer corresponding thereto are on the first surface of the silicon substrate.

2. The embedded silicon substrate fan-out type packaging structure according to claim 1, wherein a distance between the side walls of the groove and the chip is greater than 1 micron.

3. The embedded silicon substrate fan-out type packaging structure according to claim 1, wherein a distance between the bottom of the groove and the second surface of the silicon substrate is greater than 1 micron.

4. The embedded silicon substrate fan-out type packaging structure according to claim 1, wherein a height difference between the pad surface of the chip and the first surface of the silicon substrate is less than 50 microns.

5. The embedded silicon substrate fan-out type packaging structure according to claim 1, wherein the first dielectric layer is made of a polymer adhesive.

6. The embedded silicon substrate fan-out type packaging structure according to claim 1, wherein the second dielectric layer is made of a same kind of polymer adhesive as the first dielectric layer.

7. The embedded silicon substrate fan-out type packaging structure according to claim 1, wherein the adhesive layer (8) has a thickness of less than 50 microns and greater than 1 micron.

8. The embedded silicon substrate fan-out type packaging structure according to claim 1, wherein the adhesive layer is a non-conductive polymer adhesive or film.

9. The embedded silicon substrate fan-out type packaging structure according to claim 1, wherein the metal wiring is made of copper or aluminum.

10. The embedded silicon substrate fan-out type packaging structure according to claim 1, wherein the solder balls are copper pillar solder bumps or solder balls.

11. The embedded silicon substrate fan-out type packaging structure according to claim 1, wherein the under bump metal layers are made of one of Ni/Au, Cr/W/Cu, Ti/W/Cu/Ni/Au and Ti/Cu.

12. A manufacturing method for an embedded silicon substrate fan-out type packaging structure, comprising:
A. providing a silicon substrate wafer having a first surface and a second surface opposite thereto, and etching the first surface of the silicon substrate wafer to form at least one groove having a set shape and depth;
B. placing at least one chip to be packaged in the groove, with a pad surface of the chip facing upwards, a back of the chip being coated with a certain thickness of adhesive, bonding the chip and a bottom of the groove through the adhesive, and curing the adhesive to form an adhesive layer, the pad surface of the chip being close to the first surface of the silicon substrate and gaps being formed between the chip and side walls of the groove;
C. filling a polymer adhesive in the gaps between the side walls of the groove and the chip by a coating process, and curing the polymer adhesive to form an insulating first dielectric layer;
D. forming an insulating second dielectric layer on the pad surface of the chip and the first surface of the silicon substrate;
E. opening the second dielectric layer above pads of the chip, and making metal wiring connected to the pads of the chip on the second dielectric layer;
F. forming a passivation layer on the metal wiring, opening the passivation layer on the metal wiring where solder balls need to be planted, preparing required under bump metal layers on exposed metal wiring, then performing bumps preparation or solder balls plantation, and finally slicing to form an embedded silicon substrate fan-out type packaging structure.

13. The manufacturing method for an embedded silicon substrate fan-out type packaging structure according to claim 12, wherein the second surface of the silicon substrate wafer is thinned before and after the bumps preparation or the solder balls plantation, and the thickness between the bottom of the groove and the second surface of the silicon substrate is greater than 1 micron after the second surface is thinned.

14. The manufacturing method for an embedded silicon substrate fan-out type packaging structure according to claim 12, wherein the chip wafer to be packaged is thinned into a set thickness, then the adhesive is attached on a non-pad surface of the chip wafer, a single chip is formed after the chip wafer is sliced, and the chip attached with the adhesive is placed in the groove of the silicon substrate using a pick-up tool.

15. The manufacturing method for an embedded silicon substrate fan-out type packaging structure according to claim 12, wherein filling the polymer adhesive in the gaps between the side walls of the groove and the chip is implemented in a vacuum environment.

16. The manufacturing method for an embedded silicon substrate fan-out type packaging structure according to claim 12, wherein the second dielectric layer is made of a photolithographic material.
